# EUROPÄISCHE PATENTSCHRIFT

(11) **EP 2 681 979 B1**
(45) Veröffentlichungstag und Bekanntmachung des Hinweises auf die Patenterteilung: **11.03.2015**
(21) Anmeldenummer: 12701449.6
(22) Anmeldetag: 20.01.2012
(51) Int. Cl.: H05K 7/20

(54) **KÜHLEINRICHTUNG, INSBESONDERE KLIMATISIERUNGSEINRICHTUNG FÜR EINE COMPUTERANLAGE**
COOLING DEVICE, IN PARTICULAR AIR-CONDITIONING UNIT FOR A COMPUTER SYSTEM
DISPOSITIF DE REFROIDISSEMENT, EN PARTICULIER DISPOSITIF DE CLIMATISATION POUR UNE INSTALLATION INFORMATIQUE

(30) Priorität: 03.03.2011 DE 102011012948; 31.03.2011 DE 102011015756
(43) Veröffentlichungstag der Anmeldung: 08.01.2014
(73) Patentinhaber: MAUL, Martin, 36129 Gersfeld (Rhön) (DE)
(72) Erfinder: MAUL, Martin, 36129 Gersfeld (Rhön) (DE)
(74) Vertreter: Sawodny, Michael-Wolfgang
(86) Internationale Anmeldenummer: PCT/EP2012/000255
(87) Internationale Veröffentlichungsnummer: WO 2012/116769

(56) Entgegenhaltungen:
- US-A- 5 896 922
- US-A1- 2009 080 173
- US-A1- 2009 154 096
- US-B1- 6 205 796

## Beschreibung

Die Erfindung betrifft eine Kühleinrichtung, insbesondere eine Klimatisierungseinrichtung für eine elektrische Einrichtung, insbesondere eine Computeranlage, wobei die elektrische Einrichtung, insbesondere die Computeranlage in einem geschlossenen Raum untergebracht ist und die elektrische Einrichtung, insbesondere die Computeranlage wenigstens ein Gestell, insbesondere ein 19"-Rack umfasst, dass wenigstens ein elektrisches Bauelement, insbesondere einen Computer aufnimmt, wobei die Kühleinrichtung wenigstens einen Verdampfer, einen Verdichter und einen Verflüssiger umfasst.

Elektrischen Einrichtungen, insbesondere Computeranlagen erzeugen bei ihrem Betrieb Wärme. Computeranlagen sind in der Regel in einem Gestell, insbesondere einem 19"-Rack oder einem Schalt- oder Steuerschrank untergebracht. Die Schalt- oder Steuerschränke enthalten Kühlanlagen beziehungsweise Klimageräte, die dem Zweck dienen, die Luft im Schaltschrank umzuwälzen, um dabei abzukühlen. Die gesamte Kühlanlage gemäß dem Stand der Technik wird beispielsweise in der Frontwand beziehungsweise Tür oder einer Seitenwand oder im Sockel eingebaut. Beispielhafte Schriften, die Schaltschränke zeigen sind die nachfolgend:
DE 34 36 407
US 5 467 250
DE 196 01 456
DE 35 04 207
DE 88 10 228
EP 1 026 932

Die DE 34 36 407 zeigt ein Klimagerät, dass in den Innenraum eines Schaltschrankes eingeschoben werden kann. Dies hat den Nachteil, dass für Einbauten wenig Platz im Innenraum des Schaltschrankes zur Verfügung steht.

Aus der US 5,467,250 ist ein Schaltschrank bekanntgeworden, bei dem ein Wärmetauscher in die Schaltschranktür eingebaut ist.

Die DE 196 01 456 zeigt einen klimatisierten Schaltschrank mit in die Tür und/oder in ein Wandelement integriertes Klimagerät oder Wärmetauscher, wobei das Wandelement oder die Schranktür als Gehäuse zur Aufnahme der Komponenten des Klimagerätes und/oder des Wärmetauschers ausgebildet sind.

Es ist auch bekannt, ein Klimagerät auf der Außenseite einer Schaltschrankwand anzubringen. Eine derartige Anordnung zeigt die DE 35 04 207 oder auch die DE 88 10 228.

Die EP 1 026 932 zeigt ein Schaltschranksystem, dass als modulares System aufgebaut ist und durch Anbringen unterschiedlicher Kühl- oder Klimamodule auf vor bestehende Montagebereiche des Schaltschrankes unterschiedliche Kühlsysteme ermöglicht zu realisieren.

Die EP 102 6 932 ermöglicht es, je nach Bedarf Kühl- oder Klimamodule unterschiedlicher Kapazitäten und unterschiedlicher Technologien auf den Schrankkorpus als einem ersten Modul in einem vorbereiteten Montagebereich aufzusetzen.

Aus der US 2009/080173 A1 ist ein Kühlsystem mit einem Verdampfer für eine Computeranlage bekannt geworden, wobei die Verdampferschlange des Verdampfers in der Fronttüre des Gestelles für die Computeranlage untergebracht ist.

US 2009/0154096 A1 zeigt ebenfalls einen Schaltschrank, insbesondere für eine Computeranlage, bei der in einer Seitenwand des Schaltschrankes ein Verdampfer angeordnet ist.

Aus der US 5 896 922 B ist eine Kühlplatte für zwei Kühlsysteme bzw. zwei Abkühlsysteme bekannt geworden, wobei mit den Kühlsystemen bzw. Abkühlsystemen elektrische Einrichtungen, insbesondere Computeranlagen gekühlt werden.

Die US 6 205 796 B zeigt eine Feuchtigkeitsregelung für elektronische Einrichtungen, die auch eine redundante Kühlung umfasst, wobei wiederum eine Kühlplatte eingesetzt wird.

Nachteilig an einigen der zuvor beschriebenen Systemen, bei dem die Kühlung direkt im Schaltschrank erfolgte, war, dass die Wärme aus dem geschlossenen Raum nicht abgeführt wurde, sondern lediglich der Schaltschrank wurde gekühlt und die bei der Kühlung anfallende Wärme, insbesondere die Wärme des Verdichters und Verflüssigers, in den geschlossenen Raum abgegeben wurde. Hierdurch wurde der geschlossene Raum aufgeheizt, und es musste zusätzliche Kühlenergie für den Verdampfer aufgewandt werden. Ein weiterer Nachteil lag darin, dass als Kältemittel in der Regel Wasser eingesetzt wurde, was insbesondere bei Undichtigkeit dazu führte, dass flüssiges Kühlmittel in elektrische Einrichtungen eindrang, wodurch in der elektrischen Komponente, beispielsweise in den Computern Kurzschlüsse entstanden. Ein weiteres Problem bestand darin, dass die Kühlsysteme als Einzelkühlsysteme ausgelegt waren, was bedeutete, dass bei Ausfall des Kühlsystems die Computeranlage ungekühlt war, was wiederum zu einer Abschaltung der Computeranlagen bzw. der elektrischen Einrichtung führte, wenn ein einzelnes Kühlsystem ausfiel.

Aufgabe der Erfindung ist es somit, den Nachteil des Standes der Technik zu vermeiden, insbesondere eine elektrische Einrichtung mit einer Kühleinrichtung anzugeben, mit der es möglich ist, sicher die elektrische Einrichtung zu kühlen. Des Weiteren soll die Kühleinrichtung in einem geschlossenen Raum untergebracht werden können und insbesondere ein Ausfall der Kühleinrichtung vermieden werden.

Erfindungsgemäß wird die Aufgabe durch eine elektrische Einrichtung, insbesondere eine Computeranlage, mit einer Klimatisierungseinrichtung insbesondere eine Computeranlage gemäß Anspruch 1 gelöst. Die zu kühlende elektrische Einrichtung, insbesondere die Computeranlage ist in einem geschlossenen Raum untergebracht und die elektrische Einrichtung, insbesondere Computeranlage umfasst wenigstens ein Gestell, insbesondere ein 19"-Rack, das wenigstens ein elektrisches Bauelement, insbesondere einen Computer aufnimmt, wobei die Kühleinrichtung wenigstens ein Verdampfer, einen Verdichter und einen Verflüssiger umfasst. Die erfindungsgemäße Einrichtung ist dadurch gekennzeichnet, dass der Verdichter und der Verflüssiger außerhalb des geschlossenen Raumes angeordnet ist und der Verdampfer in dem Gestell, insbesondere dem 19"-Rack angeordnet und in redundanter Bauform in dem 19"-Rack ausgeführt ist.

Der Verdampfer ist derart ausgestaltet und angeordnet ist, dass gekühlte Luft wenigstens an dem elektrischen Bauelement, insbesondere dem Computer, zur Verfügung gestellt wird.

Der redundante Verdampfer ist zweiteilig umfassend wenigstens je eine getrennte Verrohrung ausbildend je einen Teilverdampfer ausgestaltet.

Erfindungsgemäß sind die wenigstens zwei Teilverdampfer in einem Gehäuse untergebracht, wobei das Gehäuse als Seitenwand des Gestelles beziehungsweise 19"-Rackes oder zumindest als Teil der Seitenwand des Gestelles beziehungsweise 19"-Rackes ausgebildet ist.

Durch die Ausgestaltung des Verdampfers in redundanter Bauweise mit zwei Teilverdampfern die in einem Gehäuse in dem Gestell beziehungsweise 19"-Rack untergebracht sind und eine Verrohrung in zwei getrennten Kreisläufen aufweisen, kann zum einen sichergestellt werden, dass bei Ausfall eines Teiles des Verdampfers beispielsweise wegen Übertemperatur durch Schalten eines Ventils sofort die andere getrennt ausgebildete Verrohrung des Verdampfers und damit der andere Teil des Verdampfers aktiviert wird, zum anderen können durch die Unterbringung in einem Gehäuse direkt im Gestell beziehungsweise 19"-Rack gegenüber einer Unterbringung in Einzelgehäusen erhebliche Materialersparnisse und eine Fertigungsvereinfachung erzielt werden.

Der Verdampfer, der im Inneren des geschlossenen Raumes angeordnet ist, ist so aufgestellt, dass eine sehr genaue Luftführung in dem Gestell, beziehungsweise 19"-Rack in dem das elektrische Bauelement angeordnet ist, zur Verfügung gestellt wird. Verdichter und Verflüssiger sind erfindungsgemäß außerhalb des geschlossenen Raumes angeordnet. Verflüssiger und Verdichter bilden gemeinsam ein Außengerät, das außerhalb des geschlossenen Raumes angeordnet und daher wetterfest ausgelegt ist. Bevorzugt ist das Außengerät für das Kältemittel R410a, R407c, R134a ausgelegt. Bevorzugt wird das Außengerät umfassend den Verdichter und den Verflüssiger auf Grundlage der Drehzahltechnik realisiert. Die Auslegung des Außengerätes umfassend Verflüssiger und Verdichter auf Grundlage der Drehzahltechnik ermöglicht eine bedarfsabhängige Drehzahlregulierung des Verdichters. Die Kältemittelmenge wird dann über das elektronische Expansionsventil geregelt und ermöglicht eine Energieeinsparung von bis zu 50%.

Die Energieersparung wird insbesondere dadurch erreicht, dass die Drehzahl des Verdichters in Abhängigkeit der von der Computeranlage und/oder dem umschlossenen Raum benötigten Kühlleistung beispielsweise zum Einhalten von Temperaturgrenzen eingestellt wird, d. h. es wird nur die benötigte Kühlmittelmenge verdichtet.

Der Verdichter des Außengerätes ist bevorzugt als Doppelrollkolbenverdichter bevorzugt schallgedämpft ausgeführt und weist einen sehr geringen Stromverbrauch bei einer sehr großen Leistung auf.

Um dies zu erreichen kann beispielsweise der Scroll-Kompressor eine Drehzahlregelung aufweisen, die zu einer sanften und gleichmäßigen Verdichtung bei geringem Geräuschpegel und geringen Schwingungen im Betrieb führt. Des Weiteren ist eine Sauggaskühlung, ein interner Motorschutz sowie ein internes Ölmanagement vorgesehen.

In einer bevorzugten Ausführungsform wird die vom Verdampfer gekühlte Luft über einen Wärmetauscher am elektrischen Bauelement zur Verfügung gestellt.

Bevorzugt wird die gekühlte Luft an wenigstens einer Seitenwand des Gestells, insbesondere des 19"-Rackes zur Verfügung gestellt. Die gekühlte Luft wird dann durch das Gestell an dem elektrischen Bauelement vorbeigeführt. Hierdurch erwärmt sich die Luft. Die erwärmte Luft wird bevorzugt, im Allgemeinen auf der Rückseite des Gestelles bzw. 19"-Rackes mittels einer Gebläseeinrichtung abgesaugt.

Um Wärmenester im Bereich des elektrischen Bauelementes zu vermeiden, ist vorgesehen, die Luft mit Hilfe von Leiteinrichtungen zu führen, beispielsweise mit Hilfe von Luftleitflächen. Die Leitflächen sind bevorzugt in dem Gestell angeordnet. Bevorzugt wird der Verflüssiger zur Verflüssigung des Kältemittels mit Außenluft, insbesondere mit Hilfe eines Ventilators gekühlt. Als Kältemittel wird in der Regel das Kältemittel R410a, R407c oder R134a eingesetzt.

Besonders bevorzugt umfasst die Kühleinrichtung wenigstens zwei geschlossene, getrennte Kältekreisläufe mit Verdichter, Verflüssiger und Verdampfer. Besonders bevorzugt ist die Kühleinrichtung mit einer Regel- und/oder Steuereinrichtung bevorzugt in Form eines Mikroprozessors versehen. Eine derartige Ausgestaltung ermöglicht es, in Abhängigkeit eines oder mehreren der nachfolgenden Steuer- bzw. Regelgrößen
- Raumtemperatur der Luft im geschlossenen Raum
- Außentemperatur außerhalb des geschlossenen Raumes
- Betriebszustand der Computeranlage, insbesondere Stromaufnahme der Computeranlage, Leistungsaufnahme der Computeranlage eine oder mehrere der nachfolgenden Einrichtung
- die Kühleinrichtung und/oder
- der Verdampfer und/oder
- das Gebläse und/oder
- den Verdichter und/oder
- den Ventilator
zu steuern und/oder zu regeln.

Bevorzugt handelt es sich bei dem Außengerät umfassend den Verdichter und Verflüssiger um das Außengerät HKL40-91 der Fa. HKL, Gersfeld, Rhön mit nachfolgenden Spezifikationen:

| | |
|---|---|
| Leistungsbereich Kühlen | 2-8kW |
| Schalldruckpegel Kühlen | 42dB(A) |
| Spannung | 230/1/50 |
| Maße Außengerät H/B/T | 815/9095/320 mm |
| Kältemittel | R 410a |
| Einspritzleitung | 10 mm |
| Saugleitung | 16 mm |
| Betriebsbereich Kühlen | -20/45°C |

Der im Gestell beziehungsweise im 19"-Rack der Computeranlage angeordnete Verdampfer, umfasst um bei einem Ausfall eines Elementes die Kühlung weiter zu gewährleisten in redundanter Bauweise zwei getrennte Verrohrungen ausbildend jeweils einen Teilverdampfer. Die Teilverdampfer sind gemeinsam in einem Gehäuse untergebracht, wobei das Gehäuse aufnehmend dem Teilverdampfer beispielsweise eine Seitenwand des Gestelles bzw. 19"-Rackes ist, in dem die Computeranlage untergebracht ist. Bevorzugt sind zwei Seitenwände des Gestelles mit je einem Verdampfer in redundanter Ausführung ausgestaltet. Der bzw. die Verdampfer in redundanter Ausführung gibt die gekühlte Luft direkt z. B. über Lüfter in das Innere des Gestelles und damit insbesondere das 19"-Rack ab.

Bevorzugt handelt es sich bei dem Verdampfer in redundanter Ausführung um einen Verdampfer HKL 5C der Fa. HKL, Gersfeld, Rhön mit folgenden Daten:

| | |
|---|---|
| Kälteleistung min./max. | 2-8 kW |
| Luftwechsel | 3600 m³/h |
| Einsatz bereich | |
| Außentemperatur Kühlbetrieb | -20° C |
| Spannungsversorgung | 230/1/50 V/Ph/Hz |
| Absicherung, träge" | 10 A |
| Leistungsaufnahme Kühlen | 0,93 kW |
| Anlaufstrom | 1,22 A |
| Spannungseinspeisung | Schaltschrank |
| Kabel, Einspeisung gem. VDE, mind.² | 3x1,5 mm² |

Die Erfindung soll nachfolgend anhand der Figuren beispielhaft beschrieben werden:
Es zeigen:
- Fig. 1a: den prinzipiellen Aufbau
- Fig. 1b: Anordnung eines Verdampfers im Gestell beziehungsweies 19"-Rack
- Fig. 2: den Aufbau eines in Fig. 1a-1b verwandten Verdampfers
- Fig. 3a - 3c: den Aufbau eines Außengerätes in die rechte Seitenwand integrierten Verdampfers
- Fig. 3d-3f: den Aufbau eines in die gegenüberliegende linke Seitenwand integrierten Verdampfers

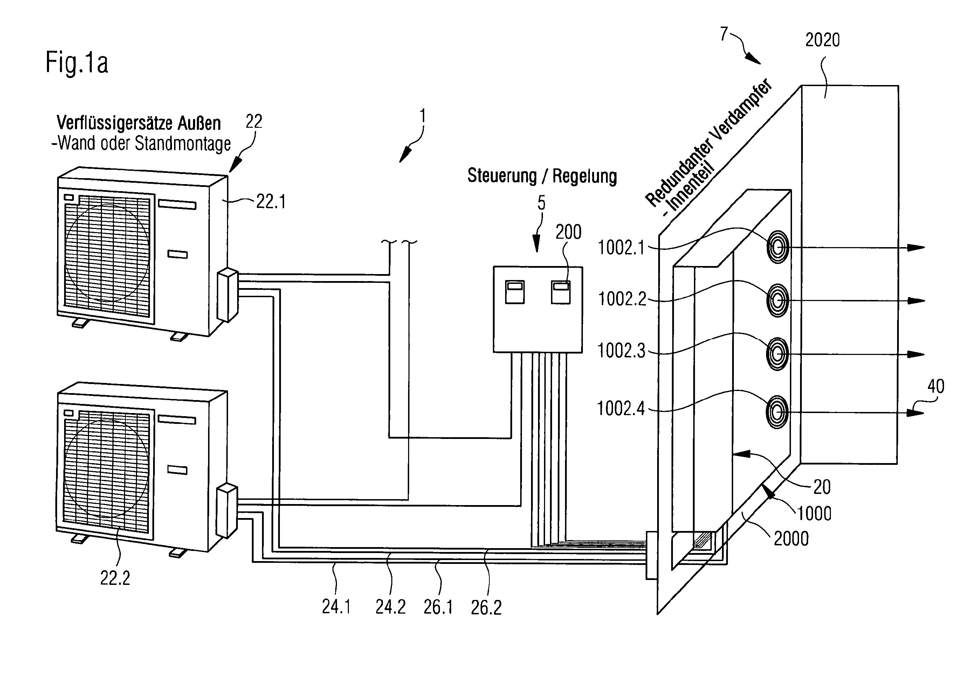

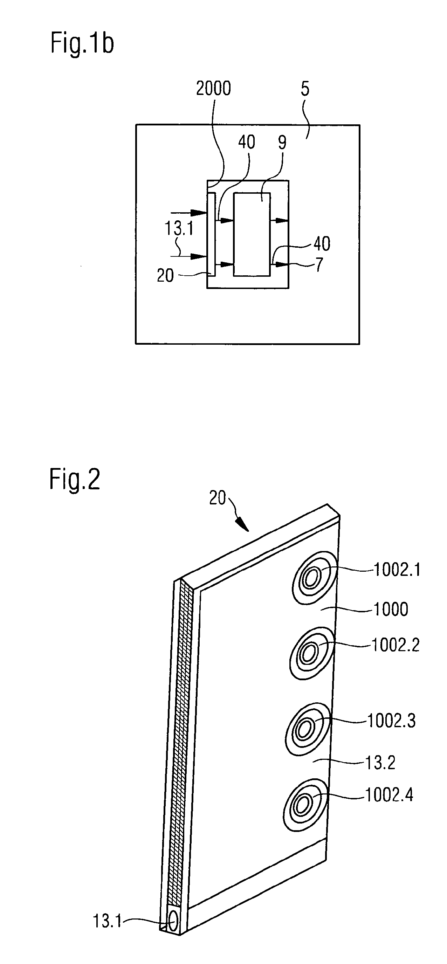

In Fig. 1 a ist der prinzipielle Aufbau der erfindungsgemäßen elektrischen Einrichtung, insbesondere einer Computeranlage, mit einer Kühleinrichtung 1 für eine elektrische Einrichtung, insbesondere eine Computeranlage, die in einem umschlossenen Raum 5 angeordnet ist, dargestellt. Die Computeranlage (nicht gezeigt) umfasst ein Gestell, 7 dass vorliegend als Rack zur Aufnahme von elektrischen Bauelementen, insbesondere Computern ausgebildet ist und schematisch dargestellt ist. Die Kühleeinrichtung 1 umfasst einen Verdampfer 20 in redundanter Ausführung sowie eine Außenkühleinrichtung 22, die außerhalb des umschlossenen Raumes 5 angeordnet ist. Die Außenkühleinrichtung 22 umfasst einen Verdichter und einen Verflüssiger (nicht dargestellt). In der Kühleinrichtung wird ein Kältemittel umgewälzt, das zunächst in dem Außengerät 22 verdichtet wird. Das verdichtende Kältemittel wird von der Außenkühleinrichtung 22 über Leitung 24.1, 24.2 zum Verdampfer 20 gefördert. Im Verdampfer 20 entspannt sich das Kältemittel.

Im vorliegenden Ausführungsbeispiel ist die gesamte Kühleinrichtung 1 redundant ausgeführt und umfasst daher zwei getrennte Kühlkreisläufe, wobei jeder Kühlkreislauf eine eigene Außenkühleinrichtung 22.1, 22.2 aufweist, sowie eine eigene Zuleitung 24.1, 24.2 zum Verdampfer 20 und eigene Ableitungen 26.1, 26.2 vom Verdampfer. Der Verdampfer 22 selbst ist auch redundant ausgeführt und weist zwei unabhängige getrennte Verrohrungen ergebend jeweils ein Teilverdampfer auf, wobei jeder Teilverdampfer je einem der zwei getrennten Kühlkreisläufe zu geordnet ist.

Wie dargestellt, sind die Teilverdampfer in einem Gehäuse 1000 mit vier Lüftern 1002.1,1000.2, 1000.3, 1000.4 untergebracht, wobei das Gehäuse mit den beiden Teilverdampfern Teil der Seitenwand des Gestelles bzw. 19"-Rackes ist.

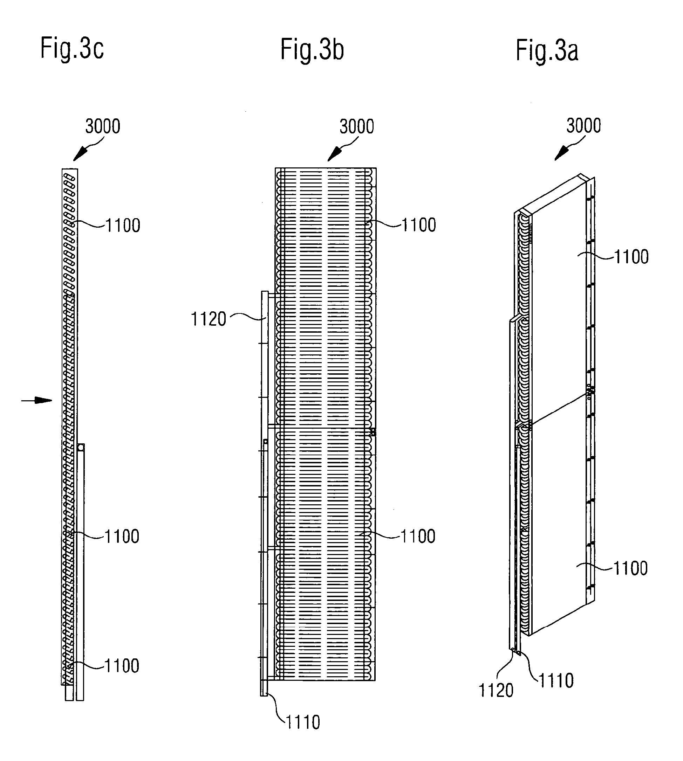

In der in den Schaltschrank beziehungsweise in Gestell, beziehungsweise in das 19"-Rack direkt eingebauten Ausführungsform eines Verdampfers 20 in redundanter Ausführungsform sind die Teilverdampfer um eine möglichst flache Bauweise zu ermöglichen beispielsweise übereinander angeordnet. Die Montage auf der Innenwand 2000 des Schaltschrankes 7 ist in Fig. 1a dargestellt, ebenso ist in Fig. 1a die Rückseite 2020 des Schaltschrankes 7 zu erkennen. Detailliert ausgeführt ist ein einzelner Teilverdampfer sowohl in einer links- wie rechtsseitigen Anschlagform in den Fig. 3a-3f.

Auch ist es möglich, anstelle eines redundanten Verdampfers im Schaltschrank beziehungsweise Gestell beziehungsweise 19"-Rack mehrere redundante Verdampfer z. B. an gegenüberliegende Seitenwände (nicht gezeigt) vorzusehen.

Es wäre auch denkbar nicht die gesamte Kühlanlage redundant mit zwei Kühlkreisläufen auszuführen, sondern nur den Verdampfer mit zwei Teilverdampfern. Diese nicht dargestellte Ausführungsform würde nur ein Außenkühlgerät 22 umfassen und einen Kühlkreislauf, der aber im Verdampfer 20 bei redundanter Ausführung des Verdampfers in zwei Teilkreisläufe aufgespalten wird, wobei de Teilkreisläufe durch ein Schaltventil in den gesamten Kühlkreislauf der Kühleinrichtung geschaltet werden. Fällt bei einer derartigen Kühleinrichtung ein Teilverdampfer aus, so wird das Schaltventil betätigt und der andere Teilverdampfer in den Kühlkreislauf geschaltet. Diese Ausführungsform weist zwar nicht die hohe Ausfallsicherheit einer Anlage mit zwei Außenkühlgeräten und zwei vollständig getrennten Kühlkreisläufen wie die in Fig. 1a dargestellte Ausführungsform auf, aber Redundanz im Bereich des Verdampfers. Denkbar, obwohl nicht gezeigt, sind Kühlanlagen mit mehr als zwei Kühlkreisläufen.

Generell ist die Funktionsweise der Kälteeinrichtung so, dass sich im Verdampfer 22 das Kältemittel entspannt. Durch die Entspannung des Kältemittels entsteht eine Abkühlung aufgrund des Joule Thompson Effekts. Das entspannte abgekühlte Gas wird über Leitung 26 zum Verdichter 22 geleitet, erneut verdichtet und am Verdampfer unter Erzeugung von Kälte entspannt. Die Kälteerzeugung mittels einer Kompressionskältemaschine ist dem Fachmann hinreichend bekannt. Diesbezüglich wird beispielsweise auf das Lehrbuch Gerthsen-Kneser-Vogel; "Physik", 13. Auflage, S. 221-224, verwiesen.

Erfindungsgemäß ist der Verdampfer derart ausgestaltet und angeordnet, dass die gekühlte Luft am elektrischen Bauelement hier am Computer zur Verfügung gestellt wird. Mittels Luftleitblechen (nicht gezeigt) wird die gekühlte Luft vom Verdampfer an dem elektrischen Bauelement vorbeigeleitet und hierbei erwärmt. Hierdurch wird wiederum das elektrische Bauelement gekühlt. Auf der dem Verdampfer gegenüberliegenden Seite können Gebläseeinrichtungen (nicht gezeigt) vorgesehen sein, mit der die durch das elektrische Bauelement erwärmte Luft in den geschlossenen Raum abgegeben wird. Der Luftstrom vom Verdampfer durch das Gestell beziehungsweise 19"-Rack ist mit 40 bezeichnet.

Der geschlossene Raum wird bei der erfindungsgemäßen Ausführung mit Außenkühlanlage lediglich durch die Abwärme der Computeranlage erwärmt, nicht jedoch durch die Wärme, die beim Verdichten des Kältemittels entsteht, da der Verdichter erfindungsgemäß in einer Außenkühlanlage 22 angeordnet ist. Auf diese Art und Weise wird der geschlossene Raum erheblich vom Wärmeeintrag entlastet, im Gegensatz zu Geräten, bei denen die Klimaeinrichtung mit all ihren Bauelementen wie beispielsweise in der EP 1 026 932 beschrieben in dem Schaltschrank beziehungsweise dem Gestell beziehungsweise 19"-Rack angeordnet sind.

In Figur 1b ist die Anordnung des Verdampfers 20 in dem Gestell beziehungsweise 19"-Rack 7 für die Computeranlage 9 in redundanter Ausführung in einem umschlossenen Raum 5 in einer Draufsicht gezeigt. Die Computeranlage 9 ist in dem Schaltschrank 7 beziehungsweise Rack untergebracht. Der Schaltschrank 7 beziehungsweise das Rack der Computeranlage 9 umfasst an wenigstens einer Seitenwand 2000 einen Verdampfer 20. Luft wird über die Seitenwand 13.1 des Verdampfers angesaugt, im Verdampfer 20 gekühlt und mittels Ventilatoren und Leiteinrichtungen wie mit Pfeilen 40 angedeutet zur jeweiligen Computeranlage 9 gefördert.

In Figur 2 ist der Verdampfer 20 nochmals detailliert dargestellt. Der Verdampfer 20 weist in der dargestellten Ausführungsform ohne hierauf beschränkt zu sein, eine Kälteleistung von 8 kW auf und ist redundant ausgeführt, d. h. er verfügt über 2 redundant miteinander verschaltete Teilverdampfer, die in ein und dasselbe Gehäuse eingebaut sind, aber jeweils einzelne, getrennte Verrohrungen aufweist.

Die Verrohrung eines Teilverdampfers kann insbesondere den Fig. 3a-3f entnommen werden.

In Fig. 2 ist hingegen insbesondere das gemeinsame Gehäuse 1000 des Verdampfers 20 gezeigt. Im gemeinsamen Gehäuse 1000 sind an der stirnseitigen Seitenwand 13.1 Öffnungen zum Ansaugen vom gasförmigen Medium, insbesondere Luft vorgesehen. Das Ansaugen von Luft wird insbesondere mittels von Lüftern - in der vorliegenden Ausführungsform vier Lüftern 1002.1, 1002.2, 1002.3 1002.4, - bewerkstelligt, die an der Seitenwand 13.2 des Gehäuses angeordnet sind. Die Kühlung der angesaugten Luft wird durch einen Verdampferblock, der zwei Teilverdampfer mit getrennten Verrohrungen umfasst, zur Verfügung gestellt.

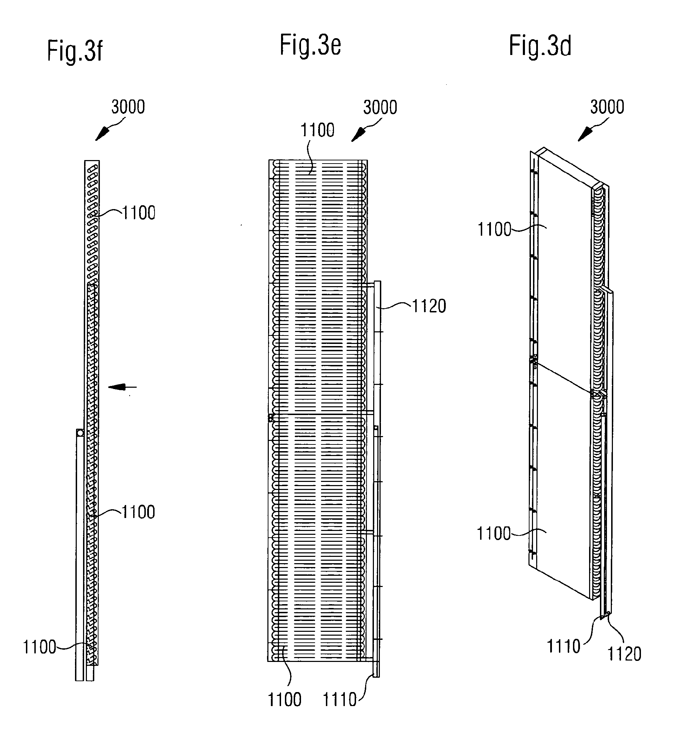

Die Einzelheiten der Teilverdampfer, die im Gehäuse 1000 des Verdampfers 20 in redundanter Ausführungsform sind detailliert in den Figuren 3a-3f gezeigt und zwar für einen rechtsseitigen Teilverdampfer in den Fig. 3a-3c und für einen linksseitigen Teilverdampfer in den Fig. 3d-3f.

Figur 3a zeigt eine dreidimensionale Ansicht eines rechtsseitigen Teilverdampfers 3000. Der rechtsseitige Teilverdampfer 3000 umfasst eine sehr flache Verrohrung 1100 mit einem Zulauf 1110 und einem Ablauf 1120 für das Kältemittel. Dies ist deutlich in der Seitenansicht gemäß Figur 3b und der Stirnansicht in Figur 3c gezeigt. In Figur 3b ist die Zuleitung mit 1110 zur Verrohrung 1100 und der Ablauf mit 1120 bezeichnet. Je zwei Teilverdampfer 3000, wie einzeln in den Fig. 3a-3c bzw. 3d-3f gezeigt, werden erfindungsgemäß in ein Gehäuse 1000, wie in Fig. 1a bzw. Fig. 2 gezeigt, integriert, ergebend den redundanten Verdampfer, der dann wieder in einem Gestell bzw. 19"-Rack, z. B. in einer Seitenwand, angeordnet ist. Hierfür ist es vorteilhaft, wenn die relativ schmalen Teilverdampfer, wie in den Fig. 3a-3f gezeigt, in dem Gehäuse übereinander angeordnet sind.

In Fig. 3d-3f ist ein auf einem Teilerdampfer in Fig. 3a-3c gegenüberliegendem Anschlag gezeigt. Hierbei werden gleiche Bezugszeichen wie in Fig. 3a-3c verwandt und Fig. 3d entspricht der 3-dimensionalen Ansicht, Fig. 3e der Seitenansicht und Fig. 3f der Frontansicht.

Neben dem Verdampfer umfasst die Kühleinrichtung 1 ein Außengerät 22, das in ein wetterfestes Gehäuse eingebaut ist. Das Außengerät 22 (in Figur 1a) ist für den Einsatz des Kältemittels R410a, R407c und R134a ausgelegt mit einer speziellen Drehzahltechnologie, durch die die Betriebskosten erheblich reduziert werden können, da sie eine bedarfsgerechte Drehzahlregelung des Verdichters ermöglichen, bevorzugt in Abhängigkeit von Messgrößen, wie Innentemperatur und/oder Außentemperatur mit Hilfe einer Regelung. Als Verdichter kommt bei dem Außengerät beispielsweise ein schallgedämpfter Doppelrollkolbenverdichter zum Einsatz. Des Weiteren umfasst das Außenkühlgerät 22 (in Figur 1 a) einen Verflüssiger, der zur Verflüssigung, beispielsweise des Kältemittels R410a luftgekühlt ist. Der Verflüssiger besteht aus einem Kupferrohr mit leistungsstarken Aluminiumrippen. Der luftgekühlte Verflüssiger lässt sich leicht reinigen, ohne dass Gehäuseteile abmontiert werden müssen. Zum Abführen der Wärme aus dem Verflüssiger beziehungsweise Verdichter umfasst das Außengerät 22 einen Axialventilator aus wärmebeständigem Kunststoff. Hierdurch wird erreicht, dass Schwingungsgeräusche nur in geringem Maße auftreten können. Durch das Kunststoffspritzgussverfahren zur Herstellung Axialventilators aus wärmebeständigem Kunststoff kann eine ideale Profilierung erreicht werden, um eine möglichst lineare und konstante Strömung durch den Ventilator zu erzielen.

Besonders bevorzugt ist es, wenn die erfindungsgemäße Einrichtung eine Regeleinrichtung, die in Fig. 1a mit 200 bezeichnet ist umfasst. Mit Hilfe von Sensoren wird zum Beispiel die Temperatur der Luft im geschlossenen Raum 5 oder der Betriebszustand der Computeranlage 9 bestimmt. Dieses Messsignal wird dann an die Steuer-/Regeleinrichtung 200 übermittelt. In Abhängigkeit von diesen Steuer- bzw. Regelgrößen wird dann das Außengerät 22 mit Verdichter bzw. Verflüssiger und/oder der Verdampfer 20 angesteuert, insbesondere die Drehzahl des Verdichters im Außengerät geregelt. Durch die Regelung beziehungsweise Steuerung mit Hilfe der Regel-, Steuereinrichtung kann die Kühlanlage sehr energiesparend betrieben werden. Des Weiteren können Betriebszustände sicher diagnostiziert und ein Testbetrieb durchgeführt werden.

Mit der Erfindung wird insbesondere erstmals ein Verdampfer in redundanter Bauweise, der einem Gehäuse untergebracht ist im Leistungsbereich 1-10 kW, bevorzugt 2-8 kW, insbesondere für eine Kühleinrichtung, insbesondere eine Klimatisierungseinrichtung angegeben, so dass ohne Unterbrechung eine Kühlung von in einem geschlossenen Raum aufgestellten elektrischen Einrichtungen, insbesondere Computeranlagen sichergestellt wird. Durch die Unterbringung in einem Gehäuse kann erheblich Material und insbesondere auch Kosten eingespart werden. Der Verdampfer wird direkt platzsparend in ein Gestell beziehungsweise Rack, das den Computer aufnimmt eingebracht.

## Patentansprüche

1. Elektrische Einrichtung, insbesondere eine Computeranlage, wobei die elektrische Einrichtung, insbesondere Computeranlage in einem geschlossenen bzw. umschlossenen Raum (5) untergebracht ist und die elektrische Einrichtung, insbesondere Computeranlage wenigstens ein Gestell (7), insbesondere ein 19"-rack umfasst, dass wenigstens ein elektrisches Bauelement, insbesondere einen Computer (9) aufnimmt, mit einer Kühleinrichtung, insbesondere Klimatisierungseinrichtung,
wobei
die Kühleinrichtung wenigstens ein Verdampfer (20), einen Verdichter und einen Verflüssiger umfasst; und
der Verdichter und der Verflüssiger außerhalb des geschlossenen bzw. umschlossenen Raumes bevorzugt in einem Außengerät (22, 22.1, 22.2) angeordnet ist,
**dadurch gekennzeichnet, dass**
- der Verdampfer (20) innerhalb des Gestelles (7), bevorzugt in einer Seitenwand (2000) angeordnet ist und der Verdampfer (20) in einer redundanten Bauform in einem einzigen Gehäuse (1000) ausgeführt ist;
- die Kühleinrichtung wenigstens zwei getrennte, geschlossene Kühlkreisläufe mit getrennten Zuleitungen (24.1, 24.2) zum Verdampfer (20) und eigene Ableitungen (26.1, 26.2) vom Verdampfer aufweist;
- der Verdampfer (20) zwei unabhängige getrennte Verrohrungen (1100) aufweist ergebend jeweils einen Teilverdampfer (3000), wobei jeder Teilverdampfer (3000) je einem der zwei getrennten Kühlkreisläufe zugeordnet ist;
- die wenigstens zwei Teilverdampfer (3000) in einem Gehäuse (1000) untergebracht sind, wobei das Gehäuse (1000) zumindest als Teil der Seitenwand (2000) des Gestelles ausgebildet ist; und
- Luft über eine Seitenwand (131) des Verdampfers (20) angesaugt, im Verdampfer (20) gekühlt und mittels Ventilatoren und Leiteinrichtungen zur jeweiligen elektrischen Einrichtung, insbesondere Computeranlage (9) gefördert wird.

2. Elektrische Einrichtung nach Anspruch 1,
**dadurch gekennzeichnet, dass**
die Kühleinrichtung wenigstens zwei Außengerät (22.1, 22.2) umfasst, die je einem Kühlkreislauf (24.1, 24.2) zugeordnet ist.

3. Elektrische Einrichtung nach einem der Ansprüche 1 bis 2,
**dadurch gekennzeichnet, dass**
der Verflüssiger umfasst:
- einen Axialventilator, bevorzugt mit einer Korbgitterkonsole, insbesondere in korrosionsgeschützter, wasserfester Ausführung.
- einen Wärmetauscher, insbesondere mit Aluminiumlamellen, die bevorzugt aufgepresst sind
- einen Drehzahlregler für den Axialventilator bevorzugt gesteuert und angeordnet in der Kondensatleitung

4. Elektrische Einrichtung nach einem der Ansprüche 1 bis 3,
**dadurch gekennzeichnet, dass**
die Kühleinrichtung wenigstens zwei elektronische Expansionsventile bevorzugt mit Drucktransmitter und Temperaturfühler umfasst.

5. Elektrische Einrichtung nach einem der Ansprüche 1 bis 4,
**dadurch gekennzeichnet, dass**
der Verdichter wenigstens zwei Scroll-Kompressoren umfasst.

6. Elektrische Einrichtung nach Anspruch 5,
**dadurch gekennzeichnet, dass**
der Scroll-Kompressor ein drehzahlgeregelter Verdichter zur Verdichtung
eines Kältemittels ist.

7. Elektrische Einrichtung nach einem der Ansprüche 1 bis 6,
**dadurch gekennzeichnet, dass**
die Kühleinrichtung eine Regel- und/oder Steuereinrichtung (200) bevorzugt, einen Mikroprozessor umfasst.

8. Elektrische Einrichtung nach Anspruch 7,
**dadurch gekennzeichnet, dass**
die Regel- und/oder Steuereinrichtung (200) in Abhängigkeit eines oder mehrere der nachfolgenden Steuer-/Regel-Größen
- der Raumtemperatur im geschlossenen Raum
- der Außentemperatur außerhalb des geschlossenen Raumes
- dem Betriebszustand der Computeranlage, insbesondere der Stromaufnahme der Computeranlage, der Leistungsaufnahme der Computeranlage
eine oder mehrere der nachfolgenden Einrichtungen:
- das Gebläse
- dem Verdampfer
- den Verdichter
- den Ventilator
steuert und/oder regelt.

## Claims

1. An electrical device, especially a computer installation, wherein the electrical device, and the computer installation in particular, is housed in a closed or enclosed space (5), and the electrical device, and the computer installation in particular, comprises at least one rack (7), especially a 19" rack, which accommodates at least one electrical component, especially a computer (9), with a cooling device, especially an air-conditioning device, wherein the cooling device comprises at least one evaporator (20), one compressor and one condenser, and the compressor and the condenser are arranged outside of the closed or enclosed space preferably in an external unit (22, 22.1, 22.2), **characterized in that**
- the evaporator (20) is arranged within the frame (7), preferably in a side wall (2000), and the evaporator (20) is arranged in redundant configuration in a single housing (1000);
- the cooling device comprises at least two separate closed cooling circuits with separate feed lines (24.1, 24.2) to the evaporator (20) and separates discharge lines (26.1, 26.2) from the evaporator;
- the evaporator (20) comprises two independent separate pipe works (1100), resulting in one partial evaporator (3000) each, wherein each partial evaporator (3000) is respectively assigned to one of the two separate cooling circuits;
- the at least two partial evaporators (3000) are housed in a housing (1000), wherein the housing (1000) is arranged at least as a part of the side wall (2000) of the rack, and
- air is sucked in via a side wall (131) of the evaporator (20), cooled in the evaporator (20), and conveyed by means of fans and guide devices to the respective electrical device, especially the computer installation (9).

2. An electrical device according to claim 1, **characterized in that** the cooling device comprises at least two external units (22.1, 22.2) which are respectively assigned to a cooling circuit (24.1, 24.2).

3. An electrical device according to one of the claims 1 to 2, **characterized in that** the condenser comprises:
- an axial fan, preferably with a wire mesh console, especially in corrosion-proof water-tight configuration;
- a heat exchanger, especially with aluminium fins which are preferably pressed onto said heat exchanger;
- a speed controller for the axial fan, preferably controlled and arranged in the condensate line.

4. An electrical device according to one of the claims 1 to 3, **characterized in that** the cooling device comprises at least two electronic expansion valves, preferably with pressure transmitter and temperature sensor.

5. An electrical device according to one of the claims 1 to 4, **characterized in that** the compressor comprises at least two scroll compressors.

6. An electrical device according to claim 5, **characterized in that** the scroll compressor is a speed-controlled compressor for compressing a refrigerant.

7. An electrical device according to one of the claims 1 to 6, **characterized in that** the cooling device comprises an open-loop and/or closed-loop control device (200), preferably a microprocessor.

8. An electrical device according to claim 7, **characterized in that** the open-loop and/or closed-loop control device (200) controls and/or regulates one or several of the following devices:
- the blower;
- the evaporator;
- the condenser;
- the fan;
depending on one or several of the following control/regulating quantities of
- the room temperature in the enclosed space;
- the external temperature outside of the enclosed space;
- the operating state of the computer installation, especially the current consumption of the computer installation, the power consumption of the computer installation.

## Revendications

1. Dispositif électrique, en particulier installation d'ordinateurs, lequel dispositif électrique, en particulier installation d'ordinateurs, est logé dans un espace (5) fermé ou entouré et lequel dispositif électrique, en particulier installation d'ordinateurs, comprend au moins un châssis (7), en particulier un tiroir de 19 pouces, qui reçoit au moins un composant électrique, en particulier un ordinateur (9), avec un dispositif de refroidissement, en particulier un dispositif de climatisation,
dans lequel le dispositif de refroidissement comprend au moins un évaporateur (20), un compresseur et un condenseur, et
le compresseur et le condenseur sont disposés à l'extérieur de l'espace fermé ou entouré, de préférence dans un appareil externe (22, 22.1, 22.2),
**caractérisé en ce que**
- l'évaporateur (20) est disposé à l'intérieur du châssis (7), de préférence dans une paroi latérale (2000), et l'évaporateur (20) est réalisé sous une forme redondante dans un seul et même boîtier (1000) ;
- le dispositif de refroidissement comprend au moins deux circuits de refroidissement fermés séparés avec des conduites d'arrivée séparées (24.1, 24.2) vers l'évaporateur (20) et des conduites de sortie (26.1, 26.2) propres hors de l'évaporateur ;
- l'évaporateur (20) présente deux tuyauteries (1100) séparées indépendantes donnant chacune une partie d'évaporateur (3000), chaque partie d'évaporateur (3000) étant associée à l'un des deux circuits de refroidissement séparés ;
- les au moins deux parties d'évaporateur (3000) sont logées dans un boîtier (1000), lequel boîtier (1000) est conformé comme au moins une partie de la paroi latérale (2000) du châssis ; et
- de l'air est aspiré via une paroi latérale (131) de l'évaporateur (20), refroidi dans l'évaporateur (20) et amené au moyen de ventilateurs et de dispositifs de guidage jusqu'au dispositif électrique, en particulier l'installation d'ordinateurs (9) à refroidir.

2. Dispositif électrique selon la revendication 1, **caractérisé en ce que** le dispositif de refroidissement comprend au moins deux appareils externes (22.1, 22.2) qui sont associés chacun à un circuit de refroidissement (24.1, 24.2).

3. Dispositif électrique selon l'une des revendications 1 à 2, **caractérisé en ce que** le condenseur comprend :
- un ventilateur axial, de préférence avec une grille de protection en console, en particulier dans une construction protégée contre la corrosion et résistante à l'eau,
- un échangeur de chaleur, en particulier à ailettes en aluminium, de préférence fixées par pressage,
- un régulateur de vitesse de rotation pour le ventilateur axial, de préférence contrôlé et disposé dans la conduite de condensat.

4. Dispositif électrique selon l'une des revendications 1 à 3, **caractérisé en ce que** le dispositif de refroidissement comprend au moins deux valves d'expansion électroniques, de préférence avec capteur de pression et sonde de température.

5. Dispositif électrique selon l'une des revendications 1 à 4, **caractérisé en ce que** le compresseur comprend au moins deux compresseurs à spirale.

6. Dispositif électrique selon la revendication 5, **caractérisé en ce que** le compresseur à spirale est un compresseur à vitesse de rotation régulée pour la compression d'un fluide de refroidissement.

7. Dispositif électrique selon l'une des revendications 1 à 6, **caractérisé en ce que** le dispositif de refroidissement comprend un dispositif de régulation et/ou de contrôle (200), de préférence un microprocesseur.

8. Dispositif électrique selon la revendication 7, **caractérisé en ce que** le dispositif de régulation et/ou de contrôle (200) contrôle et/ou régule un ou plusieurs des dispositifs suivants :
- la soufflerie,
- l'évaporateur,
- le compresseur,
- le ventilateur
en fonction d'une ou plusieurs des grandeurs de contrôle ou de régulation suivantes :
- température ambiante dans l'espace fermé
- température extérieure en dehors de l'espace fermé
- état de fonctionnement de l'installation d'ordinateurs, en particulier courant absorbé par l'installation d'ordinateurs, puissance absorbée par l'installation d'ordinateurs.
